# EUROPÄISCHE PATENTANMELDUNG

(11) **EP 3 379 725 A1**
(43) Veröffentlichungstag der Anmeldung: **26.09.2018**
(21) Anmeldenummer: 17162606.2
(22) Anmeldetag: 23.03.2017
(51) Int. Cl.: H03K 17/687, H02M 1/32, H03K 17/082

(54) **VERFAHREN ZUM STEUERN EINES GLEICHSTROMSCHALTERS, GLEICHSTROMSCHALTER UND GLEICHSPANNUNGSSYSTEM**

(71) Anmelder: Siemens Aktiengesellschaft, 80333 München (DE)
(72) Erfinder: Kaluza, Peter, 92286 Rieden (DE); Schierling, Hubert, 91052 Erlangen (DE); Weis, Benno, 91334 Hemhofen (DE)

(57) **Zusammenfassung**

Die Erfindung betrifft ein Verfahren zur Steuerung eines Gleichstromschalters (1), wobei der Gleichstromschalter (1) einen ersten abschaltbaren Halbleiterschalter (2a) und einen zweiten abschaltbaren Halbleiterschalter (2b) aufweist, wobei der erste und der zweite abschaltbare Halbleiterschalter (2a, 2b) derart zwischen einem ersten Anschluss (21) und einem zweiten Anschluss (22) angeordnet sind, dass ein Strom (i) mit einer ersten Polarität durch den ersten abschaltbaren Halbleiterschalter (2a) führbar ist und der Strom (i) mit einer gegenüber der ersten Polarität entgegengesetzten Polarität durch den zweiten abschaltbaren Halbleiterschalter (2b) führbar ist, wobei in Abhängigkeit eines Strommesswertes einer der abschaltbaren Halbleiterschalter (2a, 2b) abgeschaltet wird. Weiter betrifft die Erfindung einen Gleichstromschalter (1) mit einem ersten und einen zweiten abschaltbaren Halbleiterschalter (2a, 2b) und einer lokalen Steuervorrichtung (3) zur Durchführung eines solchen Verfahrens. Darüber hinaus betrifft die Erfindung ein Gleichspannungssystem (50) mit mindestens einer Energiequelle (5) mit einer Gleichspannung sowie mindestens einen elektrischen Verbraucher (6) mit einem Gleichspannungsanschluss und mindestens einen solchen Gleichstromschalter (1).

## Beschreibung

Die Erfindung betrifft ein Verfahren zur Steuerung eines Gleichstromschalters. Weiter betrifft die Erfindung einen Gleichstromschalter und ein Gleichspannungssystem.

Um einen Gleichstrom schalten zu können, werden Gleichstromschalter benötigt. Im Gegensatz zum Schalten von Wechselstromschaltern sind diese deutlich komplexer aufgebaut, da im Gleichstrombetrieb, wie er beispielsweise in Gleichspannungsnetzen herrscht, der Strom keinen Nulldurchgang hat, an dem ein Verlöschen des Stromes auf einfache Weise realisiert werden kann.

Derzeit am Markt befindliche Gleichstromschalter sind daher vergleichsweise teuer. Zudem sind diese oftmals nicht kurzschlussfest. Aufgrund ihrer Arbeitsweise sind sie zudem groß und schwer und somit nur unter großem Aufwand in Energieversorgungssysteme oder Antriebssysteme integrierbar.

Der Erfindung liegt die Aufgabe zugrunde, einen Gleichstromschalter und dessen Steuerung zu verbessern.

Diese Aufgabe wird durch ein Verfahren zur Steuerung eines Gleichstromschalters gelöst, wobei der Gleichstromschalter einen ersten abschaltbaren Halbleiterschalter und einen zweiten abschaltbaren Halbleiterschalter aufweist, wobei der erste und der zweite abschaltbare Halbleiterschalter derart zwischen einem ersten Anschluss und einem zweiten Anschluss angeordnet sind, dass ein Strom mit einer ersten Polarität durch den ersten abschaltbaren Halbleiterschalter führbar ist und der Strom mit einer gegenüber der ersten Polarität entgegengesetzten Polarität durch den zweiten abschaltbaren Halbleiterschalter führbar ist, wobei in Abhängigkeit eines Strommesswertes einer der abschaltbaren Halbleiterschalter abgeschaltet wird. Ferner wird die Aufgabe durch einen Gleichstromschalter mit einem ersten und einem zweiten abschaltbaren Halbleiterschalter und einer lokalen Steuervorrichtung zur Durchführung eines solchen Verfahrens gelöst, wobei der erste und der zweite abschaltbare Halbleiterschalter derart zwischen einem ersten Anschluss und einem zweiten Anschluss angeordnet sind, dass ein Strom mit einer ersten Polarität durch den ersten abschaltbaren Halbleiterschalter führbar ist und der Strom mit einer gegenüber der ersten Polarität entgegengesetzten Polarität durch den zweiten abschaltbaren Halbleiterschalter führbar ist, wobei mittels der lokalen Steuervorrichtung der Strom durch den Gleichstromschalter in Abhängigkeit eines Strommesswertes durch Abschalten eines der abschaltbaren Halbleiterschalter abschaltbar ist. Weiter wird die Aufgabe durch ein Gleichspannungssystem mit mindestens einer Energiequelle mit einer Gleichspannung, mindestens einem elektrischen Verbraucher mit einem Gleichspannungsanschluss und mindestens einem solchen Gleichstromschalter gelöst.

Weitere vorteilhafte Ausgestaltungen der Erfindung sind in den abhängigen Ansprüchen angegeben.

Der Erfindung liegt die Erkenntnis zugrunde, dass ein mechanischer DC Schalter durch einen elektronischen Schalter substituiert wird, vorzugsweise einen Transistor. Da dieser einen Strom abschalten muss, kommt ein abschaltbarer Halbleiterschalter zum Einsatz. Falls die Strom- und/oder Spannungsrichtung sich umkehrt, beispielsweise im Fall einer Rekuperation, ist der abschaltbare Halbleiter häufig mit einer antiparallelen Diode versehen, die dann den Strom in Gegenrichtung leitet. In diesem Fall kann der Strom nur dann unabhängig von seiner Stromflussrichtung, auch als Polarität bezeichnet, abgeschaltet werden wenn ein zweiter abschaltbarer Halbleiterschalter antiseriell zum ersten Schalter eingesetzt wird. Antiseriell heißt in diesem Zusammenhang, dass der zweite abschaltbare Halbleiterschalter in Reihe zum ersten abschaltbaren Halbleiterschalter angeordnet ist, allerdings einen Strom in die andere Richtung, d.h. in entgegengesetzter Polarität führen kann. Auch dieser wird mit einer Invers Diode betrieben, um einen Betrieb des Gleichstromschalters für beide Polaritäten zu ermöglichen. Alternativ können auch rückwärtssperrende IBGTs in Antiparallelschaltung eingesetzt werden. Dabei sind die beiden rückwärtssperrenden IBGTs in einer Parallelschaltung angeordnet und so ausgerichtet, dass der erste abschaltbare Halbleiterschalter den Strom mit einer ersten Polarität führen kann und der zweite abschaltbare Halbleiterschalter den Strom mit entgegengesetzter Polarität führen kann.

Alternativ hat es sich als vorteilhaft bei der antiseriellen Anordnung erwiesen, wenn die antiparallele Diode in den Chip des Transistors integriert ist. Ein solcher Schalter wird auch als rückwärtsleitender Schalter bezeichnet. Weiter ist es möglich, im Fall eines MOSFET oder JFET den Kanal in beide Stromrichtungen zu betreiben (antiparallele Anordnung).

Mit dieser Schalteranordnung ist es möglich, neben Wechselströmen auch Gleichströme zu schalten. Ein besonderer Vorteil besteht darin, dass sich im Gegensatz zu mechanischen Schaltern kein Lichtbogen innerhalb des Schalters bilden kann, der gelöscht, d.h. beseitigt, werden muss. Dabei bietet der erfindungsgemäße Gleichstromschalter zusätzlich die Möglichkeit, den Strom in nur eine Richtung zu unterbrechen. Somit kann ein elektrischer Verbraucher für die Energieaufnahme vom Netz getrennt werden, beispielsweise wenn dadurch eine Überlastung droht. Gleichzeitig kann ein Rückspeisen von Energie, beispielsweise eines Antriebs, noch ermöglicht werden, da sich dabei die Stromrichtung umdreht, d.h. die Polarität des Stroms sich ändert. Somit kann der elektrische Verbraucher gespeicherte Energie weiterhin abgeben, selbst wenn die Aufnahme von Energie mittels des Gleichstromschalters unterbrochen wurde. Dies ist aufgrund der zwei abschaltbaren Halbleiterschalter möglich.

Die weiterhin mögliche Energierückspeisung erhöht die Umweltverträglichkeit des Systems und hilft (Energie-)Kosten zu senken. Darüber hinaus können gefährliche Zustände beispielsweise für die Wartung vermieden werden, da ein Entladen der im elektrischen Verbraucher befindlichen Energiespeicher mit diesem Gleichstromschalter weiter möglich ist. Somit kann der Energiespeicher vor Beginn von Wartungsarbeiten vollständig oder zumindest nahezu vollständig entladen werden.

Bei Wechselspannungsnetzen (einphasig oder mehrphasig) werden Verbraucher häufig mit Schaltern (= Schützen) ein- und ausgeschaltet. Wird ein Reparaturschalter (= Lasttrennschalter) gefordert, kann er anstelle des Schalters eingesetzt werden. Zum Kurzschluss Schutz wird normalerweise ein Kurzschluss Schaltorgan (= Leistungsschalter) davor eingesetzt. Und zum Leitungsschutz und/oder Kurzschlussschutz des Verbrauchers kann auch eine Schmelzsicherung zum Einsatz kommen. Bei Einsatz des erfindungsgemäßen Gleichstromschalters kann das Konzept bei Wechselspannungsnetzen auf einfache Weise ohne Veränderung auf Gleichstromnetze übertragen werden.

Bei einer vorteilhaften Ausgestaltung der Erfindung erfolgt die Auswahl des abzuschaltenden abschaltbaren Halbleiterschalters in Abhängigkeit von der Polarität des Strommesswertes des Stroms. Dabei hat es sich als vorteilhaft erwiesen, den Fehlerstrom, d.h. den Strom im Fehlerfall, hinsichtlich seiner Polarität zu analysieren. Die Information über die Polarität erfordert nur 1 bit, so dass diese sich besonders einfach übertragen lässt.

Durch das Vorzeichen des erfassten Fehlerstromes oder der Spannung kann die lokale Steuervorrichtung des Schalters bestimmen, ob der Fehler lastseitig oder netzseitig von ihm aufgetreten ist. Dies ist auf einfache Weise anhand der Polarität des Stroms möglich. Je nach Polarität des Stromes, d.h. je nach Richtung des Stromes, wird dann nur der Schalter geöffnet, der in Richtung des Fehlers liegt. Dies erlaubt insbesondere bei einem netzseitigen Fehler, der durch einen Fehler in einer anderen Last oder in der oder einer der Energieversorgungseinrichtungen entstanden sein kann, den unterbrechungsfreien Weiterbetrieb der von dem Gleichstromschalter versorgten Last. Netzseitige und lastseitige Fehler lassen sich anhand der Polarität des Fehlerstromes, d.h. anhand der Polarität des Stromes im Fehlerfall erkennen. Dies kann auf einfache Weise anhand des Vorzeichens des Strommesswertes erkannt werden.

Bei einer weiteren vorteilhaften Ausgestaltung der Erfindung erfolgt die Abschaltung bei einer ersten Polarität bei einem ersten Grenzwert und bei einer der ersten Polarität entgegengesetzten Polarität bei einem zweiten Grenzwert, wobei der erste Grenzwert betraglich mindestens 25% größer ist, als der zweite Grenzwert. Es hat sich als vorteilhaft erwiesen, wenn die Auslöseschwelle des Gleichstromschalters für netzseitige Fehlerströme höher gelegt wird als die Auslöseschwelle des Schalters für lastseitige Fehlerströme. Ein Unterschied von mindestens 25%, insbesondere die Überwachung auf einen 30% höheren Fehlerstrom, bewirkt, dass bei einem Fehler in einer Last bevorzugt der direkt vorgelagerte Schalter, d.h. der Gleichstromschalter an dem dazugehörigen Verbraucher, auslöst, was eine natürliche und gewünschte Selektivität zur Folge hat.

Bei einer weiteren vorteilhaften Ausgestaltung der Erfindung wird ein Kurzschluss mittels einer U_{CE}-Überwachung erkannt und wird durch die lokale Steuervorrichtung, die zur Ansteuerung des ersten und des zweiten abschaltbaren Halbleiterschalters vorgesehen ist, insbesondere unabhängig von einer übergeordneten Steuerung, abgeschaltet. Der Gleichstromschalter mit seinen antiparallelen abschaltbaren Halbleiterschaltern wird mit einer bereits aus Wechselrichterschaltungen bekannten U_{CE}-Überwachung kombiniert, die im Falle eines Kurzschlussstromes diesen im Bereich von wenigen µs selbsttätig, ohne dass eine übergeordnete Steuerung vorhanden sein muss, abschalten kann. Die U_{CE}-Überwachung wirkt dabei auf den abschaltbaren Halbleiterschalter des Gleichstromschalters, an dem ein vorgegebener Spannungspegel überschritten wurde. Dies erlaubt insbesondere bei einem netzseitigen Fehler, der durch einen Fehler in einer anderen Last oder in der Energiequelle entstanden sein kann, den unterbrechungsfreien Weiterbetrieb der von dem Schalter versorgten Last.

Bei einer weiteren vorteilhaften Ausgestaltung der Erfindung wird die Belastung des jeweiligen abschaltbaren Halbleiterschalters durch Bildung eines i*t-Wertes oder i²*t-Wertes ermittelt, wobei bei Überschreitung eines Belastungsgrenzwertes der jeweilige abschaltbare Halbleiterschalter abgeschaltet wird. Die abschaltbaren Halbleiterschalter des Gleichstromschalters werden jeweils mit einer Strommessung ausgestattet, die damit in der Lage ist, langsam ansteigende und/oder dauerhaft über dem Bemessungswert liegende Ströme zu erfassen und nach einem i*t oder i²*t Modell oder nach einem anderen Algorithmus zur Bestimmung der Halbleiterbelastung einen evtl. Überstrom abzuschalten, der eine unzulässige Belastung, insbesondere eine unzulässig hohe thermische Belastung des Halbleiters und der Zuleitungen darstellen würde. Dadurch können langsam ansteigende Überlasten des Verbrauchers erfasst werden. Die Auswertung kann in der Elektronik des Schalters selbst oder durch die lokale Steuervorrichtung erfolgen. Im ersten Fall ist die Auslöseschwelle einstell- oder parametrierbar. Für den Fall, dass diese Strommessung Kurzschlussströme sehr schnell erkennen kann (vorzugsweise innerhalb von wenigen µs, insbesondere weniger als 10 µs), kann auf eine U_{CE}-Überwachung verzichtet werden.

Bei einer weiteren vorteilhaften Ausgestaltung der Erfindung wird eine Differenz zwischen dem Strommesswert und einem weiteren Strommesswert gebildet, wobei der weitere Strommesswert an einer Stelle erfasst wird, an der ein dem Strommesswert zugehöriger Rückstrom angenommen wird, wobei bei Überschreiten des Betrags der Differenz mindestens einer der abschaltbaren Halbleiterschalter abgeschaltet wird. In einem Abzweig zu einem elektrischen Verbraucher, der durch den Gleichstromschalter abgesichert ist, können Schalter für beide DC-Schienen angeordnet werden, die gemeinsam oder getrennt ausgelöst werden. In dieser Anordnung kann die Stromdifferenz in den beiden Schienen ermittelt werden. Die Differenz kann dabei beispielsweise zu Diagnosezwecken an eine überlagerte Steuerung gemeldet werden. So lässt sich auf einfache Weise ein Fehlerstromschutz realisieren, ohne dass weitere Elemente wie beispielsweise ein FI-Schutzschalter benötigt wird.

Bei einer weiteren vorteilhaften Ausgestaltung der Erfindung wird die Differenz frequenzselektiv, insbesondere für Frequenzen unterhalb 1 kHz, gebildet. Es hat sich als vorteilhaft erwiesen, wenn die lokale Steuervorrichtung beide abschaltbaren Halbleiterschalter öffnet, wenn die Differenz eine vorgegebene Schwelle von beispielsweise 300 mA überschreitet. Die Messung der Differenz kann im Frequenzbereich eingeschränkt sein, beispielsweise auf Frequenzen unter 1 kHz, um ein Fehlansprechen des Gleichstromschalters zu verhindern.

Bei einer weiteren vorteilhaften Ausgestaltung der Erfindung ist zwischen dem ersten Anschluss und einem der abschaltbaren Halbleiterschalter ein Schutzelement, insbesondere ein Lasttrennschalter und/oder eine Sicherung, angeordnet. Falls doch einmal, beispielsweise durch unzulässig hohe Spannungsspitzen am Gleichstromschalter, insbesondere an den abschaltbaren elektronischen Halbleiterschaltern, dieser nicht rechtzeitig abschalten kann oder beim Abschalten versagt und ein Kurzschlussstrom trotzdem sicher abgeschaltet werden soll, wird vor den Gleichstromschalter ein Sicherungselement, auch als Schutzelement bezeichnet, vorgeschaltet. Bei dem Schutzelement kann es sich in einer einfachen Ausführung um eine Sicherung wie eine Schmelzsicherung oder eine Sprengsicherung handeln. Das Ansprechen der Sicherung kann durch die lokale Steuervorrichtung des Gleichstromschalters ausgewertet und an eine übergeordnete Steuerung gemeldet werden.

Zusätzlich oder alternativ kann ein Lasttrennschalter als Reparaturschalter eingebaut werden, der sicherstellt, dass in AUS-Stellung Reparaturarbeiten am elektrischen Verbraucher durchgeführt werden können. Falls der Reparaturschalter betätigt wird, obwohl der elektronische Schalter noch eingeschaltet ist, kann durch Erfassen und Auswerten der hochfrequenten Anteile der Spannungs- und Stromsignale das Vorhandensein eines Lichtbogens, sowohl im Lasttrennschalter als auch im elektrischen Verbraucher, erkannt werden und dann mit einem der abschaltbaren Halbleiterschalter des Gleichstromschalters abgeschaltet werden. Dazu kann die gleiche Strommessvorrichtung verwendet werden, wie sie auch für das Erkennen der Polarität des Fehlerstroms verwendet wird. Somit ist dieses Verfahren besonders kostengünstig, da kein weiterer Hardwarebedarf für die Strommessung entsteht.

Die übergeordnete Steuerung kann z.B. über einen BUS den Gleichstromschalter einschalten und ausschalten. Ebenso kann der Zustand des elektronischen Schalters (ein, aus, ausgelöst, etc.) gemeldet werde. Ferner wird die Höhe der Spannungen und/oder die Höhe des Stromes erfasst und ausgewertet: bei der Erfassung der Höhe der Spannungen und/oder der Ströme an den einzelnen seriellen Schaltern kann bestimmt werden, wo eine Überlast oder ein Kurzschluss aufgetreten ist und dann selektiv abgeschaltet werden. Dabei wird in vorteilhafter Weise nur in der Richtung abgeschaltet, wo der Fehler aufgetreten ist.

Bei einer weiteren vorteilhaften Ausgestaltung der Erfindung weist die lokale Steuervorrichtung eine Schnittstelle zu einer übergeordneten Steuerung auf, wobei mittels der übergeordneten Steuerung die abschaltbaren Halbleiterschalter zu- und abschaltbar sind. Dabei kann mindestens ein Spannungswert oder Stromwert des Gleichstromschalters an eine übergeordnete Steuerung, vorzugsweise potentialfrei, über einen BUS weiter geleitet werden. Diese Spannungsmessung eröffnet die Möglichkeit, dass Selektivität sichergestellt werden kann, um einen Fehler zuverlässig zu erkennen und zu charakterisieren und seinen Fehlerort zu bestimmen. Dabei weist im einfachsten Fall diese übertragene Information nur 1 bit (|U| > Umax) oder 2 bit (U < -Umax oder U > Umax) auf. Alternativ oder ergänzend kann die Selektivität durch Einstellen von Strom-/Zeitkennlinien in der Elektronik des Schalters erzeugt werden.

Im Folgenden wird die Erfindung anhand der in den Figuren dargestellten Ausführungsbeispiele näher beschrieben und erläutert. Es zeigen:
- FIG 1: ein Gleichstromschalter, verbunden mit einem elektrischen Verbraucher und einer Energiequelle und
- FIG 2: ein Energieversorgungssystem

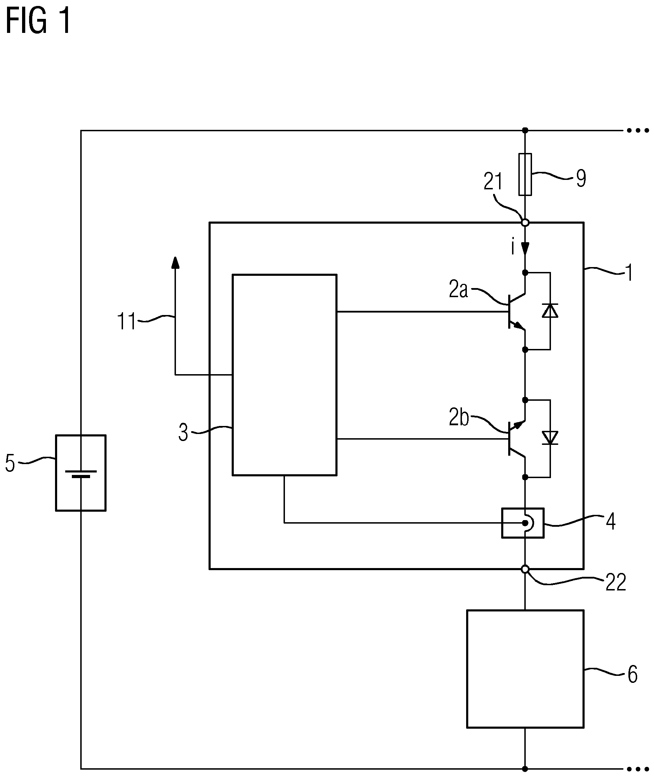

Die FIG 1 zeigt einen Gleichstromschalter 1, der mit einer Energiequelle 5 und einem elektrischen Verbraucher 6 verbunden ist. Bei der Energiequelle 5 kann es sich um einen Generator, Photovoltaikanlage, ein Energieversorgungsnetz oder auch um einen Energiespeicher, wie beispielsweise eine Batterie handeln. Der Gleichstromschalter 1 dient dazu, den elektrischen Verbraucher 6 von der Energiequelle 5 zu trennen und einen Strom i abzuschalten. Zur Messung des Stromes i dient eine Strommessvorrichtung 4, die innerhalb des Gleichstromschalters 1 oder außerhalb des Gleichstromschalters 1 angeordnet sein kann. Zwischen dem ersten Anschluss 21 des Gleichstromschalters 1 und dem zweiten Anschluss 22 sind die abschaltbaren Halbleiterschalter 2a, 2b antiseriell angeordnet. Das bedeutet, dass ein Stromfluss durch den ersten Halbleiterschalter 2a durch die zum zweiten Halbleiterschalter 2b antiparalleler Diode fließt. Bei entgegengesetzter Polarität, d.h. bei umgekehrter Stromflussrichtung fließt der Strom durch den zweiten Halbleiterschalter 2b und durch die zum ersten Halbleiterschalter 2a antiparallele Diode. Eine Antiparallele Schaltung der beiden Halbleiterschalter 2a,2b ist hier nicht dargestellt. In diesem Fall kann auf Dioden verzichtet werden, jedoch müssen die Halbleiterschalter dann rückwärts sperrfähig sein.

Zur Ansteuerung der Halbleiterschalter 2a, 2b dient die lokale Steuervorrichtung 3, die mit den Steueranschlüssen der Halbleiterschalter 2a, 2b verbunden ist. Die Steuerlogik bzw. Regelungslogik verwendet dabei als Eingangsgröße das Signal der Strommessvorrichtung 4. Zur Verbindung mit einer hier nicht dargestellten übergeordneten Steuerung 8 dient die Schnittstelle 11 zu der übergeordneten Steuerung 8.

Als weiteres Schutzelement kann in den Verbraucherabzweig eine Sicherung 9 integriert werden, die bei einer hohen Strombelastung unabhängig von dem Gleichstromschalter 1, insbesondere unabhängig von der lokalen Steuervorrichtung 3, den Schutz des elektrischen Verbrauchers 6 gewährleistet.

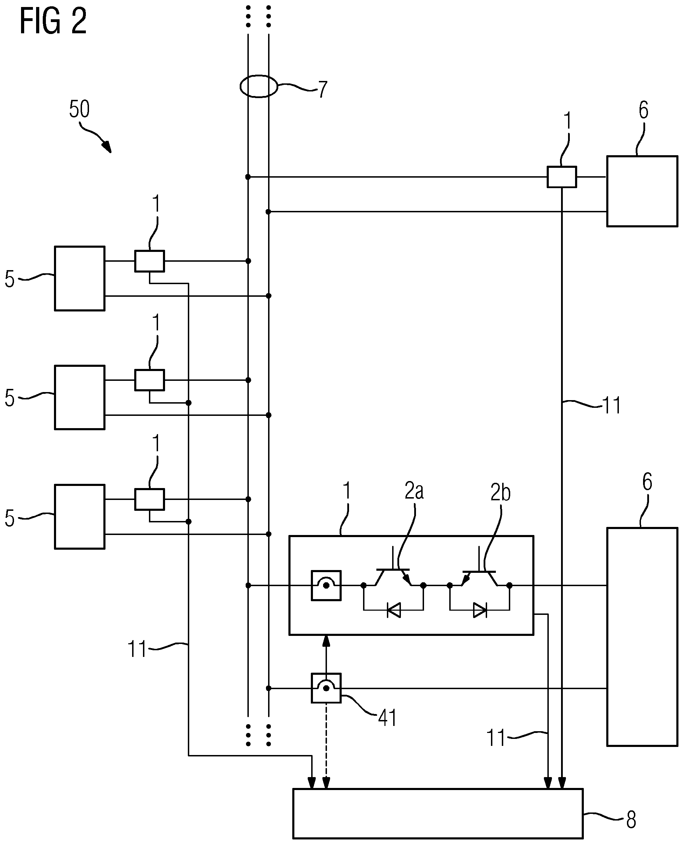

Die FIG 2 zeigt ein Gleichspannungssystem 50, das eine Vielzahl von Energiequellen 5 und elektrischen Verbrauchern 6 aufweist. Zur Vermeidung von Wiederholungen wird auf die Beschreibung zur FIG 1 und auf die dort eingeführten Bezugszeichen verwiesen. Diese Komponenten sind über eine Sammelschiene 7 miteinander verbunden. Die Sammelschiene 7 umfasst dabei einen Hinleiter und einen Rückleiter, der dem Strom zum elektrischen Verbraucher 6 (Hinleiter) und wieder zurück (Rückleiter) zur Energiequelle 5 dient. Die einzelnen Energiequellen 5 sowie die elektrischen Verbraucher 6 sind jeweils über einen oder, hier nicht dargestellt, mehrere Gleichstromschalter 1 mit der Sammelschiene 7 trennbar verbunden. Die Energieübertragung innerhalb des Gleichspannungssystems zwischen den Komponenten erfolgt mittels Gleichspannung auf der Sammelschiene 7. Dabei liegt zwischen den beiden Leitern eine Gleichspannung an.

An dem unteren elektrischen Verbraucher soll die Möglichkeit eines Fehlerstromschutzes näher erläutert werden, so dass einige wesentliche Komponenten des Gleichstromschalters 1 genauer dargestellt sind. Um einen Fehlerstromschutz herzustellen, ist eine weitere Strommessvorrichtung 41 in dem entsprechenden Verbraucherpfad vorhanden. In einem der beiden Leitern der Sammelschiene 7 ist die Strommessvorrichtung 4 angeordnet und in dem anderen Leiter die entsprechende weitere Strommessvorrichtung 41. Somit sind der Hinstrom zum elektrischen Verbraucher 6 und der Rückstrom von diesem elektrischen Verbraucher 6 messbar. Für den Fall, dass diese Ströme nicht identisch sind, d.h. die Differenz ist ungleich null, kann davon ausgegangen werden, dass ein Fehlerstrom vorhanden ist und der Gleichstromschalter öffnet seine Verbindung mittels zumindest einem der beiden abschaltbaren Halbleiterschaltern 2a,2b. Dazu kann die weitere Strommessvorrichtung 41 das Messsignal an den Gleichstromschalter 1 übermitteln. Die hier nicht dargestellte lokale Steuervorrichtung 3 wertet dieses Signal beispielsweise durch Differenzbildung mit dem Signal der Strommessvorrichtung 4 aus und leitet bei Bedarf die Schutzreaktion ein, indem sie über die Ansteuerung mindestens eines der abschaltbaren Halbleiterschalter 2a, 2b diesen Halbleiterschalter in den sperrenden Zustand versetzt.

Ebenso ist es möglich, den Fehlerstromschutz durch eine übergeordnete Steuerung 8 durchzuführen. In diesem Fall wird neben dem Signal der Strommessvorrichtung 4, die beispielsweise über eine entsprechende Schnittstelle 11 erfolgt, auch das Signal der weiteren Strommessvorrichtung 41 an die übergeordnete Steuerung 8 übertragen. Die übergeordnete Steuerung 8 kann darüber hinaus aus den Signalen der einzelnen Gleichstromschalter 1 den Betriebszustand der einzelnen Komponenten (Energiequellen 5 und elektrische Verbraucher 6) überwachen und bei Bedarf einen einzelnen oder mehrere Gleichspannungsschalter 1 ansteuern. Ebenso ist es möglich, aus diesen Informationen über den Zustand der einzelnen Komponenten im Gleichstromsystem 50 zu ermitteln.

Zusammenfassend betrifft die Erfindung ein Verfahren zur Steuerung eines Gleichstromschalters, wobei der Gleichstromschalter einen ersten abschaltbaren Halbleiterschalter und einen zweiten abschaltbaren Halbleiterschalter aufweist, wobei der erste und der zweite abschaltbare Halbleiterschalter derart zwischen einem ersten Anschluss und einem zweiten Anschluss angeordnet sind, dass ein Strom mit einer ersten Polarität durch den ersten abschaltbaren Halbleiterschalter führbar ist und der Strom mit einer gegenüber der ersten Polarität entgegengesetzten Polarität durch den zweiten abschaltbaren Halbleiterschalter führbar ist, wobei in Abhängigkeit eines Strommesswertes einer der abschaltbaren Halbleiterschalter abgeschaltet wird. Weiter betrifft die Erfindung einen Gleichstromschalter mit einem ersten und einen zweiten abschaltbaren Halbleiterschalter und einer lokalen Steuervorrichtung zur Durchführung eines solchen Verfahrens. Darüber hinaus betrifft die Erfindung ein Gleichspannungssystem mit mindestens einer Energiequelle mit einer Gleichspannung sowie mindestens einen elektrischen Verbraucher mit einem Gleichspannungsanschluss und mindestens einen solchen Gleichstromschalter.

## Patentansprüche

1. Verfahren zur Steuerung eines Gleichstromschalters (1), wobei der Gleichstromschalter (1) einen ersten abschaltbaren Halbleiterschalter (2a) und einen zweiten abschaltbaren Halbleiterschalter (2b) aufweist, wobei der erste und der zweite abschaltbare Halbleiterschalter (2a,2b) derart zwischen einem ersten Anschluss (21) und einem zweiten Anschluss (22) angeordnet sind, dass ein Strom (i) mit einer ersten Polarität durch den ersten abschaltbaren Halbleiterschalter (2a) führbar ist und der Strom (i) mit einer gegenüber der ersten Polarität entgegengesetzten Polarität durch den zweiten abschaltbaren Halbleiterschalter (2b) führbar ist, wobei in Abhängigkeit eines Strommesswertes einer der abschaltbaren Halbleiterschalter (2a,2b) abgeschaltet wird.

2. Verfahren nach Anspruch 1, wobei die Auswahl des abzuschaltenden abschaltbaren Halbleiterschalters (2a,2b) in Abhängigkeit von der Polarität des Strommesswertes des Stroms (i) erfolgt.

3. Verfahren nach Anspruch 2, wobei die Abschaltung bei einer ersten Polarität bei einem ersten Grenzwert erfolgt und bei einer der ersten Polarität entgegengesetzten Polarität bei einem zweiten Grenzwert erfolgt, wobei der erste Grenzwert betraglich mindestens 25% größer ist als der zweite Grenzwert.

4. Verfahren nach einem der Ansprüche 1 bis 3, wobei ein Kurzschluss mittels einer U_{CE}-Überwachung erkannt wird und durch die lokale Steuervorrichtung (3), die zur Ansteuerung des ersten und des zweiten abschaltbaren Halbleiterschalters (2a,2b) vorgesehen ist, insbesondere unabhängig von einer übergeordneten Steuerung (8), abgeschaltet wird.

5. Verfahren nach einem der Ansprüche 1 bis 4, wobei die Belastung des jeweiligen abschaltbaren Halbleiterschalters (2a,2b) durch Bildung eines i*t-Wertes oder i²*t-Wertes ermittelt wird, wobei bei Überschreitung eines Belastungsgrenzwertes der jeweilige abschaltbare Halbleiterschalter (2a,2b) abgeschaltet wird.

6. Verfahren nach einem der Ansprüche 1 bis 5, wobei eine Differenz zwischen dem Strommesswert und einem weiteren Strommesswert gebildet wird, wobei der weitere Strommesswert an einer Stelle erfasst wird, an der ein dem Strommesswert zugehöriger Rückstrom angenommen wird, wobei bei Überschreiten des Betrags der Differenz mindestens einer der abschaltbaren Halbleiterschalter (2a,2b) abgeschaltet wird.

7. Verfahren nach Anspruch 6, wobei die Differenz frequenzselektiv, insbesondere für Frequenzen unterhalb 1 kHz, gebildet wird.

8. Gleichstromschalter (1) aufweisend
- einen ersten und einen zweiten abschaltbaren Halbleiterschalter (2a,2b)
- eine lokale Steuervorrichtung (3) zur Durchführung des Verfahrens nach einem der Ansprüche 1 bis 7,
wobei der erste und der zweite abschaltbare Halbleiterschalter (2a,2b) derart zwischen einem ersten Anschluss (21) und einem zweiten Anschluss (22) angeordnet sind, dass ein Strom (i) mit einer ersten Polarität durch den ersten abschaltbaren Halbleiterschalter (2a) führbar ist und der Strom (i) mit einer gegenüber der ersten Polarität entgegengesetzten Polarität durch den zweiten abschaltbaren Halbleiterschalter (2b) führbar ist, wobei mittels der lokalen Steuervorrichtung (3) der Strom (i) durch den Gleichstromschalter (1) in Abhängigkeit eines Strommesswertes durch Abschalten eines der abschaltbaren Halbleiterschalter (2a,2b) abschaltbar ist.

9. Gleichstromschalter (1) nach Anspruch 8, wobei der erste und der zweite abschaltbare Halbleiterschalter (2a,2b) jeweils eine U_{CE}-Überwachung aufweisen.

10. Gleichstromschalter (1) nach einem der Ansprüche 8 oder 9, wobei zwischen dem ersten Anschluss (21) und einem der abschaltbaren Halbleiterschalter ein Schutzelement, insbesondere ein Lasttrennschalter und/oder eine Sicherung (9), angeordnet ist.

11. Gleichstromschalter (1) nach einem der Ansprüche 8 bis 10, wobei der Gleichstromschalter (1) eine Strommessvorrichtung (4) und/oder eine Spannungsmessvorrichtung (42) aufweist.

12. Gleichstromschalter (1) nach einem der Ansprüche 8 bis 11 wobei die lokale Steuervorrichtung (3) eine Schnittstelle (11) zu einer übergeordneten Steuerung (8) aufweist, wobei mittels der übergeordneten Steuerung (8) die abschaltbaren Halbleiterschalter (2a,2b) zu- und abschaltbar sind.

13. Gleichspannungssystem (50) umfassend
- mindestens eine Energiequelle (5) mit einer Gleichspannung
- mindestens ein elektrischer Verbraucher (6) mit einem Gleichspannungsanschluss
- mindestens ein Gleichstromschalter (1) nach einem der Ansprüche 8 bis 12.
